Europäisches Patentamt

European Patent Office

Office européen des brevets

(11) Veröffentlichungsnummer : **0 167 929**
**B1**

(12) **EUROPÄISCHE PATENTSCHRIFT**

(45) Veröffentlichungstag der Patentschrift :
10.02.88

(21) Anmeldenummer : **85107921.0**

(22) Anmeldetag : **26.06.85**

(51) Int. Cl.⁴ : **H 01 L 29/743**

(54) Halbleiter-Leistungsschalter mit Thyristor.

(30) Priorität : **12.07.84 DE 3425719**

(43) Veröffentlichungstag der Anmeldung :
**15.01.86 Patentblatt 86/03**

(45) Bekanntmachung des Hinweises auf die Patenterteilung : **10.02.88 Patentblatt 88/06**

(84) Benannte Vertragsstaaten :
**AT CH DE FR GB IT LI SE**

(56) Entgegenhaltungen :
**DE-A- 2 447 621**
**FR-A- 2 412 169**
**US-A- 3 324 359**
**US-A- 3 437 889**
**US-A- 4 236 169**

(73) Patentinhaber : **Siemens Aktiengesellschaft Berlin und München**
**Wittelsbacherplatz 2**
**D-8000 München 2 (DE)**

(72) Erfinder : **Lehmann, Erhard, Dipl.-Ing.**
**Römerstrasse 58**
**D-8011 Aschheim (DE)**

Jouve, 18, rue St-Denis, 75001 Paris, France

## Beschreibung

Die vorliegende Erfindung bezieht sich auf einen Halbleiter-Leistungsschalter mit einem Thyristor, dem eine Diode in Reihe geschaltet ist.

Solche Leistungsschalter bestehen nach dem Stand der Technik im allgemeinen aus symmetrisch sperrenden Thyristoren mit der Zonenfolge $n^+pnp^+$. Symmetrisch sperrender Thyristor bedeutet, daß der Thyristor sowohl in der Kipprichtung als auch in der Sperrichtung eine wenigstens annähernd gleichgroße Spannung sperren kann. Im leitenden Zustand sind die schwach dotierten Mittelzonen des Thyristors mit Ladungsträgern überschwemmt. Wird ein solcher Thyristor dann gesperrt, so müssen die im Inneren des Halbleiterkörpers des Thyristors gespeicherten Ladungsträger ausgeräumt werden. Ist die Ladung ausgeräumt, so kann der Thyristor Sperrspannung aufnehmen. Die Ladung wird daher Sperrverzögerungsladung $Q_{rr}$ genannt und ist eine charakteristische Größe eines jeden Thyristors. Sie hängt im wesentlichen von der Dicke der Mittelzone, d. h. von der maximal möglichen Sperrspannung, ab und ist in etwa dem Quadrat der Dicke der Mittelzone proportional. Mit steigender maximaler Sperrspannung wächst daher die Größe $Q_{rr}$ überproportional an.

Die gespeicherte Ladung hat zur Folge, daß der Thyristor unmittelbar nach dem Nulldurchgang des Stroms noch nicht sperren kann. Durch den Thyristor kann daher ein Rückstrom so lange weiterfließen, bis die Ladungsträger aus der Mittelzone annähernd ausgeräumt sind. Etwa beim Scheitelpunkt des Rückstroms beginnt der Thyristor, Sperrspannung aufzunehmen. Werden solche Thyristoren an induktiven Lasten betrieben, so baut sich an der Induktivität eine Spannung auf, die den Thyristor in Sperrichtung beansprucht. Die Höhe dieser Spannung wird von der Höhe des Rückstroms und damit von der Größe der Sperrverzögerungsladung sowie von den Stromkreisparametern und einer RC-Beschaltung bestimmt.

Die Speicherladung ließe sich zwar dadurch verringern, daß die Außenzonen des Thyristors schwächer dotiert werden. Damit wird aber auch die Durchlaßspannung des Thyristors größer und die im Thyristor umgesetzte Verlustleistung steigt an.

Der Erfindung liegt die Aufgabe zugrunde, eine Halbleiter-Leistungsschalter mit einem Thyristor so weiterzubilden, daß bei gegebener Sperrspannung die Sperrverzögerungsladung und damit auch die Freiwerdezeit geringer wird, ohne die Durchlaßspannung $U_T$ zu vergrößern.

Diese Aufgabe wird dadurch gelöst, daß dem asymmetrisch sperrenden Thyristor eine Diode in Reihe geschaltet ist, wobei die Diode derart dimensioniert ist, daß in ihr eine höhere Sperrverzögerungsladung gespeichert ist als im Thyristor.

Unter einen asymmetrisch sperrenden Thyristor, wie er beispielsweise in US-PS 4 236 169 beschrieben ist, versteht man einen Thyristor, der im wesentlichen nur in Vorwärtsrichtung Sperrspannung $U_{DRM}$ aufnehmen kann. In Rückwärtsrichtung kann ein solcher Thyristor nur eine wesentlich geringere Sperrspannung von einigen 10 V aufnehmen. Ein weiterer Thyristor ist z. B. in der US-PS 3 324 359 beschrieben. Dort ist zwischen einer Basiszone ersten Leitfähigkeitstyps und einem Emitter zweiten Leitfähigkeitstyps eine stark dotierte Schicht ersten Leitfähigkeitstyps angeordnet, die dort zur Verbesserung der Abschaltverstärkung angeordnet ist.

In der US-PS 3 437 889 ist ein Halbleiterschalter beschrieben, dessen Rückwärtssperrspannung dadurch einstellbar ist, daß ein mit Anoden- und Kathodenkurzschlüssen versehener und damit lokale Diodenbereiche aufweisender und damit rückwärtsleitender Thyristor eine Diode gleichsinnig in Reihe geschaltet hat. Die Rückwärtssperrspannung des dort beschriebenen Halbleiterschalters ist durch die Wahl der Sperrspannung der in Reihe geschalteten Diode frei wählbar. Eine Reduzierung der Freiwerdezeit des Halbleiterschalters spielt in den genannten Veröffentlichungen keine Rolle.

Ein bevorzugtes Ausführungsbeispiel unserer Erfindung besteht darin, daß dem Thyristor eine Hilfsdiode antiparallel geschaltet ist. Weitere zweckmäßige Ausgestaltungen sind Gegenstand der Unteransprüche.

Die Erfindung wird anhand zweier Ausführungsbeispiele in Verbindung mit den Fig. 1, 2 und 4, 5 näher erläutert. Es zeigen :

Fig. 1 ein Schaltbild eines ersten Ausführungsbeispiels,

Fig. 2 ein Schaltbild eines weiteren, bevorzugten Ausführungsbeispiels,

Fig. 3 einen schematischen Schnitt durch einen asymmetrisch sperrenden Thyristor,

Fig. 4 und 5 die Seitenansicht auf je eine Halbleitereinheit, die aus den Halbleiterkörpern von asymmetrischem Thyristor und Diode bestehen.

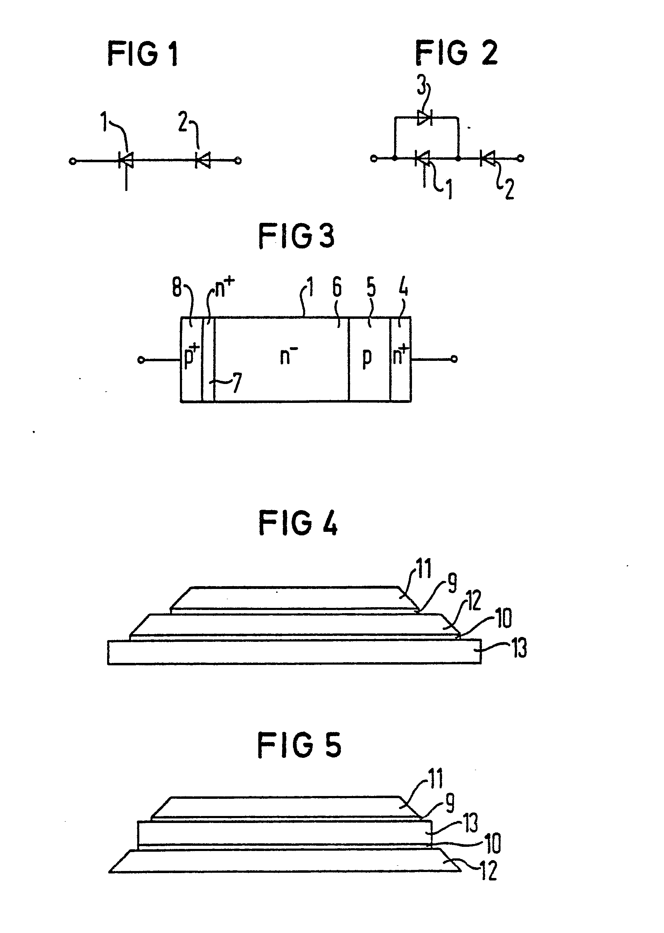

Der Halbleiter-Leistungsschalter nach Fig. 1 besteht aus einem asymmetrisch sperrenden Thyristor 1 und einer Diode 2, die dem Thyristor 1 in Reihe geschaltet ist. Die Diode 2 kann dabei wie gezeigt dem Thyristor 1 anodenseitig oder auch katodenseitig in Reihe geschaltet sein. Der Aufbau des asymmetrisch sperrenden Thyristors 1 ist schematisch in Fig. 3 angedeutet. Er besteht aus zwei hochdotierten Außenzonen 4 und 8, die stark n- bzw. stark p-dotiert sind. An die stark dotierte Außenzone 4 schließt sich eine schwächer p-dotierte Zone 5 an. An die Zone 5 schließt sich eine schwach n-dotierte Zone 6 an. Diese hat im Vergleich zu allen anderen Zonen die größte Dicke. Zwischen der schwach n-dotierten Zone 6 und der stark p-dotierten Zone 8 liegt eine sogenannte Stopschicht 7, die stark n-dotiert ist. Diese Zone 7 bewirkt, daß sich die Raumladungszone des Thyristors 1 ausgehend vom pn-Übergang zwischen den Zonen 5 und 6 bis in die Zone 7 ausbreiten kann. Damit ergibt sich in erster Näherung wegen des günstigeren Feldstärkeverlaufs in der Zone 6 eine Verdoppelung der Sperrspannung in Vorwärtsrichtung $U_{DRM}$ gegenüber einem symmetrisch sperrenden Thyristor mit gleicher Dicke der schwach n-dotierten Zone.

Ähnliche Verhältnisse wie für den asymmetrisch sperrenden Thyristor ergeben sich für eine Diode, da diese im allgemeinen eine Zonenfolge $p^+pn^-n^+$ hat. Damit benötigt auch eine Diode nur etwa die halbe Breite der schwach dotierten Mittelzone wie ein symmetrisch sperrender Thyristor mit gleichhoher Sperrspannung. Da, wie eingangs erwähnt, die Sperrverzögerungsladung etwa proportional dem Quadrat der Dicke der schwach dotierten Mittelzone ist, ergibt sich für den Halbleiter-Leistungsschalter nach Fig. 1 in erster Näherung eine halb so große Speicherladung wie für einen symmetrisch sperrenden Thyristor gleicher Sperrspannung. Bei einer Dimensionierung auf gleiche Sperrverzögerungsladung ist die Durchlaßspannung des Halbleiter-Leistungsschalters nach Fig. 1 geringer als die Durchlaßspannung eines symmetrisch sperrenden Thyristors mit gleicher Sperrspannung, da eine Diode verglichen mit einem Thyristor von gleicher Sperrspannung und gleicher aktiver Fläche einen geringeren Durchlaßwiderstand zeigt. Einen Halbleiter-Leistungsschalter mit symmetrischen Sperreigenschaften erhält man dann, wenn die Sperrspannung in Vorwärtsrichtung $U_{DRM}$ des Thyristors 1 gleich der Sperrspannung in Rückwärtsrichtung $U_{RRM}$ der Diode 2 ist.

Wird ein Leistungschalter nach Fig. 1 in Stromrichtern, z. B. in Gleichstrom-Choppern betrieben, so wird der Thyristor 1 mit Rückstrom belastet, d. h., daß der Thyristor in den Avalanche-Durchbruch geht. Da nicht jeder ASCR für diesen Betrieb gleich gut geeignet ist, z. B. kann eine deutliche Freiwerdezeiterhöhung auftreten, wird dem Thyristor 1 vorzugsweise eine Diode 3 antiparallel geschaltet, wie in Fig. 2 dargestellt. Der Rückstrom fließt dann durch die antiparallelgeschaltete Hilfsdiode 3 und vermeidet eine höhere Sperrbelastung des ASCR.

Gemäß der Erfindung ist es erforderlich, die Diode 2 so zu dimensionieren, daß ihre Sperrverzögerungsladung $Q_{rr}$ größer als die des Thyristors 1 ist. In diesem Fall kann der Thyristor schnell ausgeräumt werden. Ist die Sperrverzögerungsladung der Diode kleiner als die des Thyristors, müssen die Ladungsträger im Thyristor nach beendetem Ausräumen der Diode durch Rekombination verschwinden, was einer Erhöhung der Freiwerdezeit gleichkommt.

Die Schalter nach den Fig. 1 und 2 können mit diskreten Bauelementen aufgebaut werden. Es ist jedoch z. B. möglich, die Hilfsdiode 3 in den Halbleiterkörper des Thyristors 1 zu integrieren. Solche Thyristoren sind als rückwärts leitende Thyristoren (RLT) bekannt (vgl. z. B. US-A-4 236 169). Es ist auch möglich, die Halbleiterkörper von Thyristor 1 und Diode 2 zu einer Einheit zusammenzufügen. Eine erste Möglichkeit ist in Fig. 4 dargestellt. Hier ist der Halbleiterkörper des Thyristors 1 mit 11 bezeichnet, der Halbleiterkörper der Diode 2 mit 12. Die Halbleiterkörper 11 und 12 können durch eine Legierungsschicht 9 miteinander verbunden werden. Dabei liegt zweckmäßigerweise die Anodenseite des Halbleiterkörpers 11 des Thyristors an der Katodenseite des Halbleiterkörpers 12 der Anode 2. Die Einheit ist durch eine Trägerscheibe 13 verstärkt, die mit der Einheit durch eine Legierungsschicht 10 verbunden ist. Die Trägerscheibe 13 besteht in bekannter Weise aus Molybdän oder Wolfram.

Es ist auch möglich, die Halbleiterkörper 11 und 12 beidseitig an die Trägerscheibe 13 anzulegieren, wie in Fig. 5 gezeigt. Auch hier ist der Halbleiterkörper 11 des Thyristors 1 zweckmäßigerweise mit der Anodenseite an die Trägerplatte 13 anlegiert, da die Katodenseite im allgemeinen die Gate-Strukturen enthält. Der Halbleiterkörper 12 der Diode 2 ist dann anodenseitig mit der Trägerplatte 13 verbunden.

## Patentansprüche

1. Halbleiter-Leistungsschalter mit einem asymmetrisch sperrenden Thyristor (1), eine Diode (2) in Reihe geschaltet ist, wobei die Diode (2) derart dimensioniert ist, daß in ihr eine höhere Sperrverzögerungsladung gespeichert ist als im Thyristor (1).

2. Halbleiter-Leistungsschalter nach Anspruch 1, dadurch gekennzeichnet, daß dem Thyristor (1) eine Hilfsdiode (3) antiparallelgeschaltet ist.

3. Halbleiter-Leistungsschalter nach Anspruch 1 oder 2, dadurch gekennzeichnet, daß die Hilfsdiode (3) in den Halbleiterkörper des Thyristors (1) integriert ist.

4. Halbleiter-Leistungsschalter nach einem der Ansprüche 1 bis 3, dadurch gekennzeichnet, daß die Halbleiterkörper (11, 12) von Thyristor und Diode derart zusammenlegiert sind, daß die Anodenseite des Halbleiterkörpers des Thyristors an der Katodenseite des Halbleiterkörpers (12) der Diode anliegt, und daß an der Anodenseite des Halbleiterkörpers (12) der Diode eine Trägerplatte (13) anlegiert ist.

5. Halbleiter-Leistungsschalter nach einem der Ansprüche 1 bis 3, dadurch gekennzeichnet, daß der Halbleiterkörper (11) des Thyristors anodenseitig auf eine Seite einer Trägerplatte (13) auflegiert ist und daß der Halbleiterkörper (12) der Diode katodenseitig auf die andere Seite der Trägerplatte (13) auflegiert ist.

## Claims

1. A semiconductor power switch comprising an asymmetrically blocking thyristor (1) with which a diode (2) is connected in series, where the diode (2) is dimensioned such that a higher reverse recovery charge is stored in the diode than in the thyristor (1).

2. A semiconductor power switch as claimed in Claim 1, characterised in that an auxiliary diode (3) is connected to the thyristor (1) in anti-parallel fashion.

3. A semiconductor power switch as claimed in Claims 1 or 2, characterised in that the auxiliary diode (3) is integrated into the semiconductor body of the thyristor (1).

4. A semiconductor power switch as claimed in Claims 1, 2 or 3, characterised in that the semiconductor body (11, 12) of the thyristor and the diode are alloyed together in such manner that the anode side of the semiconductor body of the thyristor contacts the cathode side of the semiconductor body (12) of the diode, and that a carrier plate (13) is alloyed to the anode side of the semiconductor body (12) of the diode.

5. A semiconductor power switch as claimed in one of Claims 1, 2 or 3, characterised in that the semiconductor body (11) of the thyristor is alloyed on the anode side to one side of a carrier plate (13), and that the semiconductor body (12) of the diode is alloyed on the cathode side to the other side of the carrier plate (13).

**Revendications**

1. Interrupteur de puissance à semiconducteurs comportant un thyristor (1) réalisant un blocage asymétrique, avec lequel est branchée en série une diode (2), qui est dimensionnée de telle sorte qu'en elle se trouve stockée une charge de retardement de blocage, plus élevée que dans le thyristor (1).

2. Interrupteur de puissance à semiconducteurs suivant la revendication 1, caractérisé par le fait qu'une diode auxiliaire (3) est branchée selon un montage antiparallèle avec le thyristor (1).

3. Interrupteur de puissance à semiconducteurs suivant la revendication 1 ou 2, caractérisé par le fait que la diode auxiliaire (3) est intégrée dans le corps semiconducteur du thyristor (1).

4. Interrupteur de puissance à semiconducteurs suivant la revendication 1, 2 ou 3, caractérisé par le fait que les corps semiconducteurs (11, 12) du thyristor et de la diode sont réunis par formation d'un alliage de telle sorte que le côté anode du corps semiconducteur du thyristor est contigu au côté cathode du corps semiconducteur (12) de la diode et qu'une plaque de support (13) est fixée par formation d'un alliage au côté anode du corps semiconducteur (12) de la diode.

5. Interrupteur de puissance à semiconducteurs suivant l'une des revendications 1, 2 ou 3, caractérisé par le fait que le corps semiconducteur (11) du thyristor est fixé par formation d'un alliage, côté anode, sur une face d'une plaque de support (13) et que le corps semiconducteur (12) de la diode est fixé par formation d'un alliage, côté cathode, sur l'autre face de la plaque de support (13).

# FIG 1

# FIG 2

# FIG 3

# FIG 4

# FIG 5